# EUROPEAN PATENT APPLICATION

(11) **EP 4 626 160 A1**
(43) Date of publication of application: **01.10.2025**
(21) Application number: 24167856.4
(22) Date of filing: 29.03.2024
(51) Int. Cl.: H05K 7/20, H05K 9/00

(54) **METAL BODY DESIGNED TO BE MAINTAINED IN CLOSE CONTACT WITH A PCB IN A VEHICLE DEVICE**

(71) Applicant: Plastic Omnium Lighting Systems GmbH, 80807 München (DE)
(72) Inventor: FEIL, Thomas, 80807 MUNICH (DE); DIRR, Christoph, 80807 MUNICH (DE)
(74) Representative: LLR

(57) **Abstract**

Heatsink (2) or housing designed to be held in close contact with a PCB (1) in a vehicle lamp, with the PCB having a hole (9) and being designed to be supported in a predetermined position on the heatsink, characterized in that a protruding shape (11) is provided on the heatsink, at a location so that the protruding shape penetrates the hole when the PCB is almost in its predetermined position on the heatsink, and the protruding shape is dimensioned so that the PCB plastically deforms (16) the protruding shape when the PCB is forced into its predetermined position on the heatsink.

## Description

### Technical field

The technical field of the invention is automobile lighting. More precisely, the lighting device or assembly used in individual cars, trucks, and any other type of vehicle for providing lighting, i.e. headlamps, side lamps, rear lamps, light control units.

### Background art

Within the housing of a lamp, optical parts and electronic parts are arranged in such a way that they take up an amount of space as small as possible, allowing the lamp to meet any design requirements of the car maker.

Although electronic components are usually not cumbersome, they generate a lot of heat and need to be cooled down by a heatsink. The electronic components are mounted on a printed circuit board (or "circuit board" or "PCB") and the PCB is thermally linked to the heatsink, to evacuate the heat. The PCB and the heatsink are affixed close to one another. Since the heatsink is a bloc of thermally and electrically conductive material, usually aluminium, the risk is known that the heatsink may act as a ground mass. Potential differences between PCB and heatsinks will discharge in the area with the smallest electrical resistance and cause sparks which can destroy the electrical components.

This known risk is eliminated thanks to an electrical connection between the heatsink and the PCB, established by dedicated means that are intentionally added for this purpose. An example of such means is disclosed in EP 1 615 488 where a housing has a deformable projection that engages with a hole in the PCB and establishes electrical ground connection contact with a conductive zone of the PCB. The deformation of the projection results from the operation of a specific tool.

Another common solution is a screw linking the PCB to the heatsink or housing.

### Technical problem

Dedicated means are electrically efficient. They indeed prevent sparks from destroying the electronic components of the PCB. However, they increase the cost and require additional manpower for their provisioning, handling, assembling and maintenance.

### Solution to Problem

The invention proposes a solution to above disadvantages for any PCB and heatsink or housing that are designed to be maintained in close contact with each other in a vehicle lamp or light control unit, with the PCB supported in a predetermined position on the heatsink or housing.

In this description, the heatsink or housing is a metal body, possibly but not necessarily die cast, of a vehicle lighting device, designed to be maintained in close contact with the PCB.

In this description, "lighting device" means any part of the vehicle that provides lighting. It can also be an assembly that is affixed to the vehicle without being separable part. It can comprise a light source or not. For instance, it can be a light control unit, only comprising components that are part of the lighting chain.

An object of the invention is a combination of a PCB and a metal body that are designed to be maintained in close contact with each other in a vehicle lighting device.

According to the invention, the PCB comprises a hole and a conductive layer in contact with the metal body when the PCB is in its predetermined position relative to the metal body. The metal body is provided with a protruding shape at a location such that the protruding shape penetrates the hole when the PCB is almost in its predetermined position relative to the metal body. The protruding shape is dimensioned so that at least one of the conductive layer and the protruding shape deforms plastically to adapt their geometry to each other when the PCB is forced into its predetermined position relative to the metal body.

According to the invention, a plastic deformation is a deformation that changes the geometry in a way that cannot be restored simply by suppressing the constraints, for instance by cutting the PCB to open the hole. After deformation, matching shapes of the protruding shape and PCB provide a form fitting function. The stress of the thus created mechanical connection after deformation may be low, even released completely during lifetime, due to differences in the thermal expansion coefficient, but the form fitting function of the mechanical connection will last.

### Advantageous Effects of Invention

Thanks to the deformation of either the protruding shape or the conductive layer of the PCB, that occurs at the end of the positioning of the PCB on the metal body, an electrical connection is established between the PCB and the metal body. No additional tool nor additional piece is required. No additional step in the assembly process is needed.

The deformation serves two purposes.

Firstly, the deformation gives the PCB freedom for its exact positioning on the metal body. Should it be a heatsink, the positioning is in favour of optimal thermal regulation of the PCB. Should it be a housing, the positioning is in favour of the best holding of the PCB. The protruding shape may be used in addition to other referencing means. The present invention does not alter this optimal positioning. Should the protruding shape not be exactly aligned with the hole of the PCB, then said protruding shape would deform asymmetrically and adjust to the intended predetermined position of the hole. The protruding shape may also be used as a referencing means, then the protruding shape is used for its self-centring effect and the deformation is symmetric.

Secondly, when the deformation occurs on the protruding shape, the deformation cuts into the surface and removes part of the possibly oxidized outer face of the metal body. This oxidized outer surface is usually less electrically conductive than the metal, or even electrically insulating. For example, if the metal body is made of aluminium, and the PCB hole has a copper layer on its wall the PCB ground track, then the copper layer, which has a higher hardness than the aluminium, deforms the aluminium protruding shape and removes the oxidized layer during insertion. After insertion, the contact areas on the protruding shape are deformed and make contact with the ground track.

It should be noted that even if the outer surface of the metal body is oxidized again after cutting and becomes less conductive, the intimate contact between the protruding shape and the ground track remains sufficient to create a preferential path for electrical current, thus still avoiding any risk of sparking.

An advantage of the hole is it that frees the PCB from constraints in areas not surrounding the hole. Indeed, constraints tend to remain in the vicinity of the hole, with the forces generated by the deformed protruding shape being balanced internally by the wall of the hole.

As a preferred configuration, the protruding shape and the hole are such that, after plastic deformation of the protruding shape, the residual force exerted by the protruding shape on the wall of the hole is lower than 20 N/mm². As already explained, this force will decrease with time.

Preferably, the protruding shape and the hole are designed such that the insertion force required to place the PCB in its predetermined position is between 10 N and 200 N, preferably 80 N for one protruding shape.

Normally, in a housing, various components are stacked and held together by mechanical means, so that there is no need for any fixing means between the PCB and the metal body. In such a case, the invention does not require any change in the technical means for holding the components together.

If there is a mechanical retaining means which does not act as an electrical connection, then the invention can be implemented to provide the missing electrical connection without further modification.

In the housing, the components are stacked according to a stacking direction. This stacking direction is typically the direction in which the PCB and metal body are moved towards each other during assembly.

In a preferred embodiment, the protruding shape protrudes from the metal body in the stacking direction. Thus, when the PCB and metal body are assembled, the electrical connection between them is also established by deformation of the protruding shape. No specific step of the assembly process is required.

In a preferred embodiment, the protruding shape has a converging cross-section in a plan parallel to the stacking direction. The converging cross-section assists in the insertion of the protruding shape into the hole due to its self-centring effect.

The cross-section of the protruding shape in a plan perpendicular to the stacking direction can follow several geometries.

In a preferred embodiment, a triangular cross-section increases contact at edges in each direction with minimal but sufficient deformation of the protruding shape for a limited amount of force required when pushing the PCB into its predetermined position.

According to another embodiment, the cross-section in a plan perpendicular to the stacking direction is a square. In another embodiment, it is a hexagon, or an octagon. The higher the number of edges, the more resistant the protruding shape will be to insertion, because of the number of edges to be deformed and the size of the contact areas at the edges, as this size depends on the angle of each edge. At most, an infinite number of edges corresponds to a shape with a circular cross-section (a cylindrical shape or a conical shape).

According to a particular embodiment, there are resting means around the protruding shape which are configured to leave an empty space at the bottom of the protruding shape before and after the PCB has reached its predetermined position on the metal body. This provision ensures that the PCB reaches its predetermined position without being blocked by a volume of material displaced by deformation, or by metal shavings or chips cut from the protruding shape during insertion of the protruding shape into the hole. This provision is of course not compulsory, as the end position of the PCB is not always a priority and if additional stress to the PCB does not destroy the components on it. In this case, no resting means are needed and potential chips or the deformed material will then be pressed between PCB back side and the metal body face.

Resting means can be a flat bank surrounding the protruding shape, slightly projecting from a main face of the metal body, and a groove between the bottom of the protruding shape and the bank.

The groove has the advantage that it can retain the shavings or chips that may be cut from the protruding shape, preventing them from moving freely in the housing.

The depth of the groove is between 0.1 mm and 0.5 mm, preferably 0.3 mm.

The width of the groove is between 1 mm and 2 mm, preferably 1.5 mm.

An alternative to the bank and groove is a set of at least one stud, the end of which serves as resting face for the PCB in its predetermined position.

Another object of the invention a headlamp, side lamp, rear lamp, or light control unit of a vehicle, comprising a metal body and a PCB as described above.

### Brief description of drawings

In order to make the object, technical schemes and advantages of the present application clearer, it will be described in more detail with reference to the accompanying drawings and embodiments. Example embodiments are shown in the accompanying drawings, where the same or similar designations represent the same or similar elements or elements having the same or similar functions. The embodiments described below with reference to the accompanying drawings are exemplary and are intended only to explain the present application and are not to be understood as limiting the present application. Furthermore, it should be understood that the specific embodiments described herein are intended to illustrate rather than limit the present application.
[Fig. 1] is a perspective view of a PCB mounted on a heatsink,
[Fig. 2] is a zoom of part II of figure 1,
[Fig. 3] is a zoom of part III of figure 2,
[Fig. 4] is a top view of a corner part of the heatsink,
[Fig. 5] is a perspective view of the same corner part,
[Fig. 6] is a top view of the PCB positioned above the heatsink, before it is inserted in its predetermined position,
[Fig. 7] is a perspective view similar to Fig.5 of the heatsink alone, after the PCB has been inserted,
[Fig. 8] is a perspective view of the PCB, once inserted in its predetermined position on the heatsink,
[Fig. 9] is a top view of the PCB and heatsink, once the PCB, represented by a transparent body, is inserted in its predetermined position,
[Fig. 10] is a cross-section along X-X of Fig.9,
[Fig. 11] is a top view of the heatsink after insertion of the PCB,
[Fig. 12] is a perspective view of a housing and a PCB of a light control unit,
[Fig. 13] is zoom of part XIII of figure 12,
[Fig. 14] is a perspective cross-section along the XIV-XIV plane of Fig. 13,
[Fig. 15] is a view similar to figure 13 of another embodiment of the housing and PCB,
[Fig. 16] is a perspective cross-section along the XVI-XVI plane of Fig. 15

In the description of the present application, it is to be understood that the terms "length", "width", "top", "bottom", "front", "rear", "horizontal" and "vertical" indicate an orientation or positional relationship based on the orientation or positional relationship illustrated in the accompanying drawings, solely to facilitate the description of the present application, rather than to indicate or imply that the devices or elements mentioned must have a particular orientation, be constructed and operate in a particular orientation, and therefore cannot be understood as a limitation of the present application.

Furthermore, the terms "upper" and "lower" or "first" and "second" are used for illustrative purposes only and should not be understood to indicate or imply the relative importance or number of the technical features referred to. Accordingly, the features defined by "first" and "second" may explicitly or implicitly include at least one or more features. In the description of the present application, the expression "several" refers to at least two features, unless otherwise specified.

In the description of the present application, it should be noted that, unless otherwise indicated and limited, the terms "predetermined position" and "connection" are to be understood in a broad sense; for example, they may include a relative position of one piece relative to another one, not an absolute position.

Similarly, a "connection" is a mechanical connection unless specified as a thermal connection.

In the present application, the phrase "A is supported on B" means that A and B are firmly attached to each other, regardless of which is carrying the other.

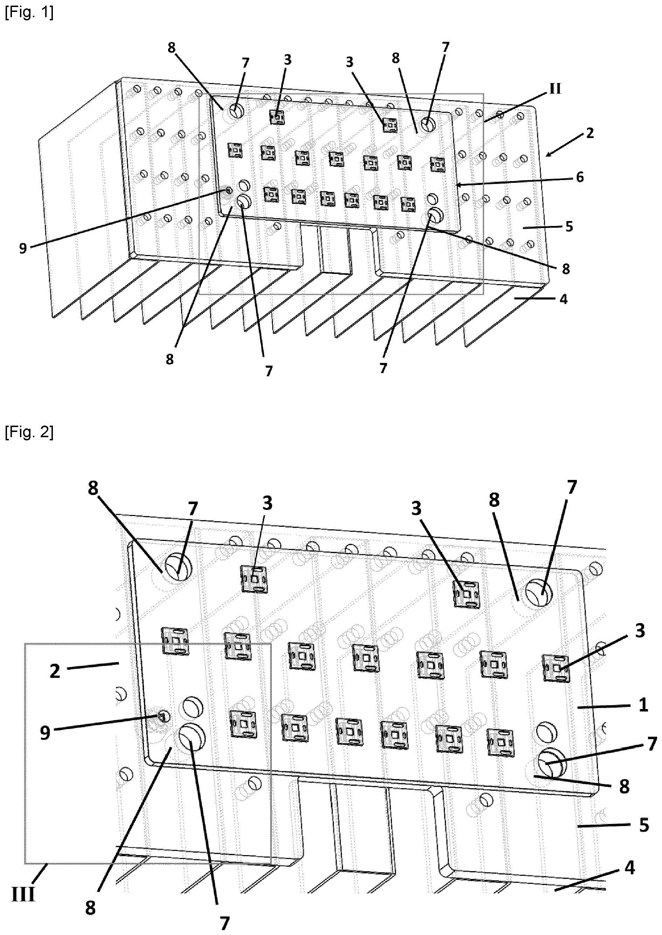

The combination of a PCB 1 and a heatsink 2 shown in Figure 1 is taken from a vehicle headlight. PCB 1 contains electronic components 3, in the broadest sense of the word, including light emitting diodes (LEDs).

PCB 1 is supported on heatsink 2 by a flat surface called the "contact area".

In Figure 1, heatsink 2 comprises radiators 4 at the rear and a front face 5 with a flat rectangular support area 6 designed to receive PCB 1. Heatsink 2 is cast in aluminium.

The dimensions of PCB 1 are similar to the dimensions of heatsink support area 6.

PCB 1 has a conductive copper layer 1a covering its face, which houses electronic components 3.

At each corner of PCB 1, fastening holes 7 are aligned with holes 8 of heatsink 2, for receiving a fastening means (not shown) which ensures that heatsink 2, PCB 1 and additional internal components (not shown) of the headlight are stacked in their predetermined position. All the internal components are stacked along a stacking direction which is perpendicular to PCB 1 and to contact area 6 of heatsink 2.

The left bottom corner of PCB 1 has a through hole 9, in an area of the PCB covered by the conductive layer. Conductive layer 1a extends into a wall 10 of hole 9, down to the lower side of PCB 1, where said conductive layer 1a also extends locally.

Hole 9 has a circular cross section.

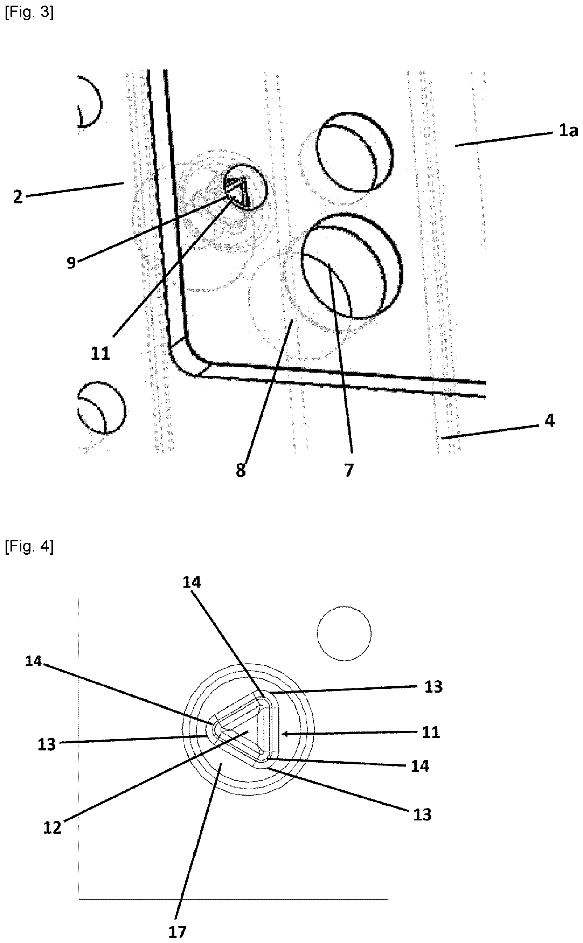

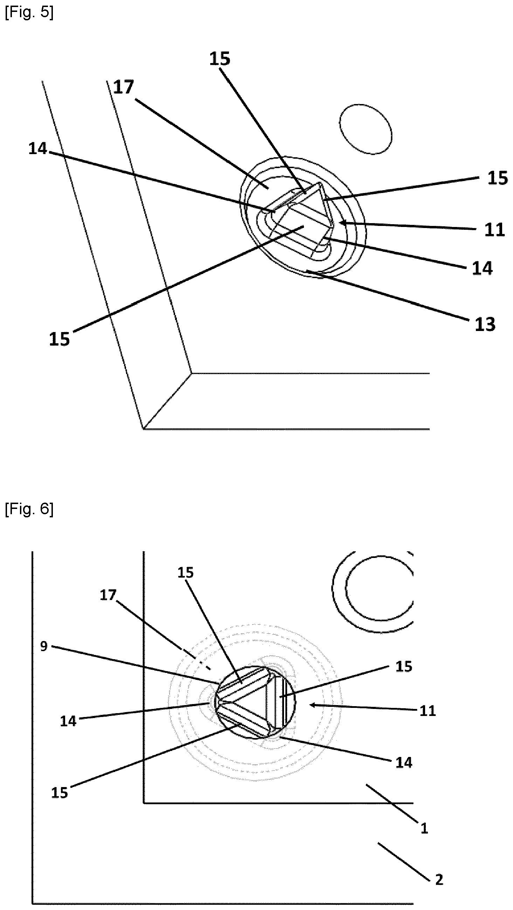

On heatsink 2, as shown specifically in Figures 4 to 11, there is a protruding shape 11 facing hole 9 of PCB 1 when PCB 1 is in its predetermined position.

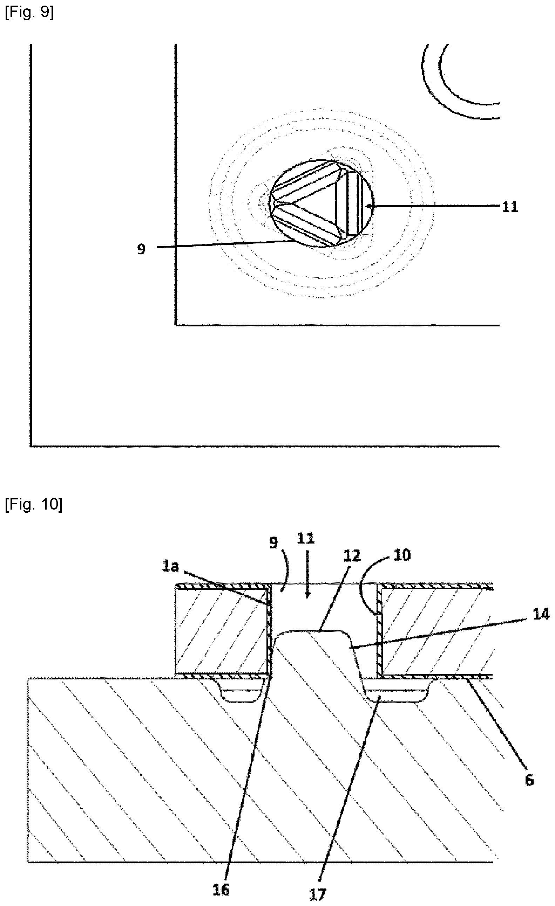

Protruding shape 11 has a conical envelope, i.e. a converging cross-section in a plane parallel to the stacking direction, as shown in Fig. 10. Protruding shape is a truncated cone with a flat top surface 12 parallel to contact area 6.

As shown in Fig. 4, the cross-section of protruding shape 11, in a plane perpendicular to the stacking direction, is a triangle with rounded corners 13. Each corner, in 3D, represents an edge 14 of the protruding shape. In this example, protruding shape 11 has three edges 14. In alternative embodiments (not shown), the protruding shape has more edges. It may also have fewer edges. Between the edges, the protruding shape has three side faces 15 arranged as the walls of a pyramid.

An upper part, e.g. half, of protruding shape 11 is dimensioned to have a cross-section, in a plane parallel to the contact area, which is smaller than the cross-section of hole 9. It can therefore penetrate the hole without any resistance.

A lower part, e.g. another half, of protruding shape 11 is dimensioned to have a cross-section, in a plane parallel to the contact area, which is larger than the cross-section of hole 9, at least in the region of edges 14 of protruding shape 11. In the region of side faces 15, protruding shape 11 is smaller than the hole.

As a result, when PCB 1 is pushed onto heatsink 2, the upper part of protruding shape 11 enters hole 9 until edges 14 of protruding shape 11 meet wall 10 of hole 9. At this stage, a force is required to push PCB 1 around hole 9. In the example shown, this force varies from 40 N to 200 N at the end of the insertion.

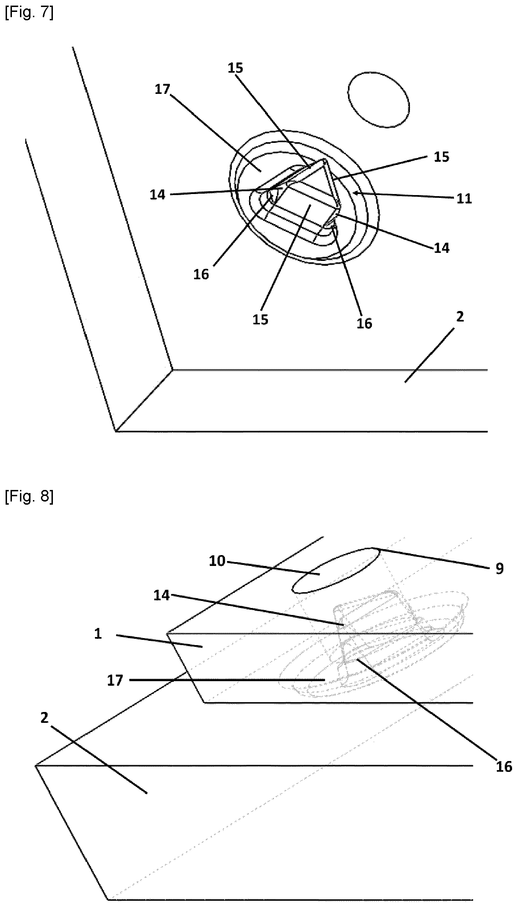

Since the copper of conductive layer 1a is harder than the aluminium of protruding shape 11, edges 14 of said protruding shape 11 deform plastically as protruding shape 11 is inserted. Conductive layer 1a cuts the edges in a location 16, as shown in figures 7 and 10. The cut at location 16 may also be a deformation. Most likely, there is both a cut and a deformation.

Slight deformation of the conductive layer 1a is also possible, but generally that little so that it is not shown on the figures. In another embodiment (not shown), the deformation occurs also on the conductive layer or both on the conductive layer and protruding shape.

Cutting edges 14 creates an electrical connection between conductive layer 1a of PCB 1 and the solid aluminium of heatsink 2. If the heatsink is covered with an oxidized layer, cutting of the edges removes this oxidized layer and brings the copper of the conductive layer into direct contact with solid aluminium.

Once protruding shape 11 has been fully inserted into hole 9, the electrical connection established between conductive layer 1a and heatsink 2 is maintained as long as the stacked internal components of the headlamp are held in their stacked predetermined position by the fastening means.

Around protruding shape 11, heatsink 2 is casted with a circumferential groove 17. Groove 17 surrounds protruding shape 11 and digs into heatsink 2 by approximately 0,3 mm.

Groove 17 ensures correct positioning of PCB 1 on heatsink 2, whatever the deformation of the edges of the protruding shape.

Groove 17 leaves an empty space for material deformation of the protruding shape and for receiving any chips and shavings removed when cutting or crushing edges 14 of protruding shape 11.

An unillustrated alternative to the groove and bank is a set of studs arranged around the protruding shape.

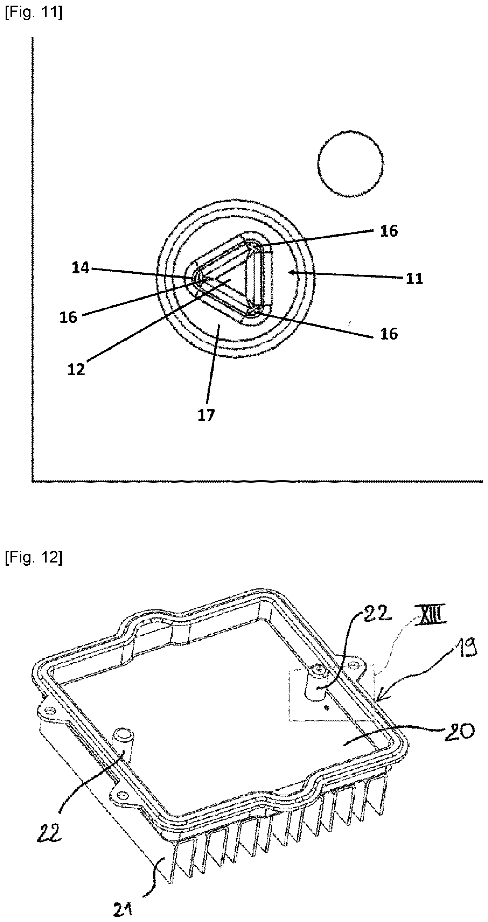

In the embodiment of figures 12-14, one can see a housing 19 and a PCB 20 of a light control unit. The electronic components of PCB 20 are not shown. The PCB has a conductive layer

Housing 19 has radiators 21 that dissipate the heat generated by the components.

Positioning studs 22 are integral with housing 19. Studs 22 ensure that PCB 20 is maintained on housing 19 in a predetermined position. Studs 22 may have additional functions which are not described here.

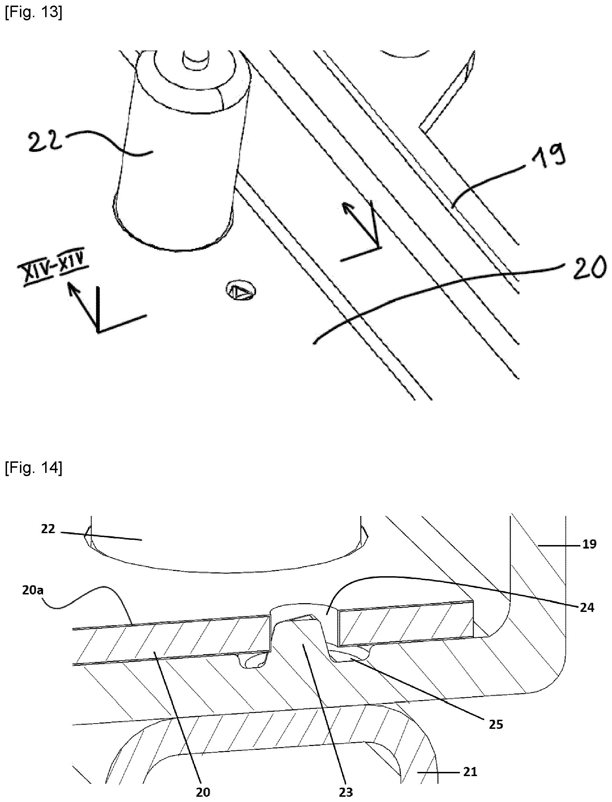

As more visible in figure 13, housing 19 comprises one protruding shape 23 configured and shaped as the one 11 already described and shown in figures 1-12.

Protruding shape 23 penetrates a hole 24 of PCB 20. Since the positioning of PCB 20 is ensured by studs 22, hole 24 has no centring function. As already explained, the plastic deformation of protruding shape 23 is possibly asymmetrical if the location of hole 24 is not exactly centred on protruding shape 23 when PCB 20 is in its predetermined position in housing 19.

A groove 25 is also provided around protruding shape 24, as in the preceding embodiment. Groove 25 could not exist if PCB 20 can endure a deformation or a stress that does not destroy the components on it.

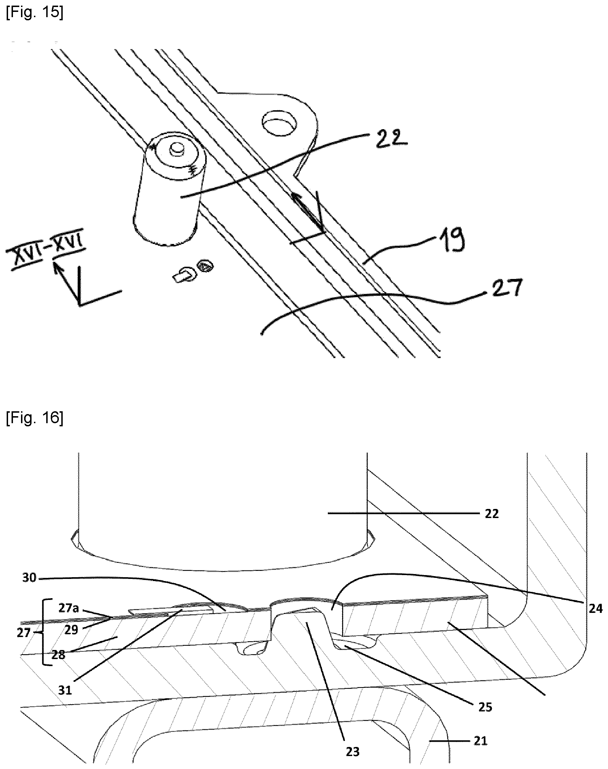

In the embodiment of figures 15-16, identical objects are identified by the same reference number as in figures 12-14. PCB 27 is an IMS-PCB, i.e. an "insulated metal substrate PCB", also known as "metal core PCB", constructed with an aluminium support plate 28 separated by a dielectric layer 29 from an upper copper conductive layer 27a. In another embodiment, an IMS-PCB base Copper is used, instead of an IMS-PCB base Aluminium.

Dielectric layer 29 transfers heat from conductive layer 27a to aluminium support plate 28. Aluminium support plate 28 acts as a heatsink and provides structural support for PCB 27. The dielectric layer material has the qualities of excellent heat dissipation and great dielectric strength against high voltages.

An electrically conductive connection is created between the ground circuit of upper copper conductive layer 27a and aluminium support plate 28.

On PCB 27, dielectric layer 29 of the ground circuit is partially removed using a z-axis drilling process, thus creating a depression 30 in the copper layer, which exposes aluminium support plate 28. In depression 30, an electrically conductive carbon ink 31 is deposited using a screen-printing process. Other processes which are capable of electrically connecting the upper layer with the aluminium support e.g. bonding or gluing with an electrically conductive glue would also work. Hence, aluminium support plate 28 is electrically connected to the ground circuit of upper copper conductive layer 27a.

Thanks to protruding shape 23 and hole 24, housing 19 is also electrically connected to aluminium support plate 28. As a result, when PCB 27 is inserted in its predetermined position, housing 19 is electrically connected to the ground circuit of upper copper conductive layer 27a.

### List of references

- 1 ...: PCB
- 1a ...: conductive layer
- 2 ...: heatsink
- 3 ...: electronic components
- 4 ...: radiators
- 5 ...: front face
- 6 ...: contact area
- 7 ...: fastening holes on PCB
- 8 ...: fastening holes on heatsink
- 9 ...: hole
- 10 ...: wall
- 11 ...: protruding shape
- 12 ...: top face
- 13 ...: corners
- 14 ...: edges
- 15 ...: side faces
- 16 ...: location of cutting and/or deformation
- 17 ...: groove
- 19 ...: housing
- 20 ...: PCB
- 20a ...: conductive layer
- 21 ...: radiators
- 22 ...: positioning studs
- 23 ...: protruding shape
- 24 ...: hole
- 25 ...: groove
- 27 ...: PCB
- 27a ...: upper copper conductive layer
- 28 ...: aluminium support plate
- 29 ...: dielectric layer
- 30 ...: depression
- 31 ...: carbon ink

## Claims

1. **Combination of a PCB (1; 20; 27) and a metal body (2; 19)** that are designed to be maintained in close contact with each other in a vehicle device, the PCB (1; 20; 27) having a predetermined position relative to the metal body (2; 19), the PCB (1; 20; 27) comprising a hole (9; 24) and a conductive layer (1a; 27a) in contact with the metal body (2; 19) when the PCB (1; 20; 27) is in its predetermined position relative to the metal body (2; 19), **characterized in that** the metal body (2; 19) is provided with a protruding shape (11; 24) at a location such that the protruding shape (11; 24) penetrates the hole (9; 24) when the PCB (1; 20; 27) is almost in its predetermined position relative to the metal body (2; 19), and the protruding shape (11; 24) is dimensioned so that at least one of the conductive layer (1a; 27a) and the protruding shape (11; 24) deforms plastically to adapt their geometry to each other when the PCB (1; 20; 27) is forced into its predetermined position relative to the metal body (2; 19).

2. Combination according to claim 1, wherein the metal body (2) forms a heatsink (2) able to dissipate heat from the PCB (1) when in close contact with the PCB (1; 20; 27).

3. Combination according to claim 1, wherein the metal body forms a housing (19) of the vehicle device able to hold the PCB (20; 27).

4. Combination according to any one of the preceding claims, wherein, when the deformation occurs on the protruding shape, the deformation cuts into the surface and removes part of the possibly oxidized outer face of the metal body.

5. Combination according to any one of the preceding claims, wherein the protruding shape (11; 24) and the hole (9; 24) are designed such that the insertion force required to force the PCB (1; 20; 27) in its predetermined position is between 10 N and 200 N, preferably 80 N for one protruding shape.

6. Combination according to any one of the preceding claims, wherein components of the vehicle lamp are stacked according to a stacking direction and the protruding shape (11; 24) protrudes from the metal body (2; 19) in the stacking direction.

7. Combination according to any one of the preceding claims, wherein the protruding shape (11; 24) has a converging cross-section in a plan parallel to the stacking direction.

8. Combination according to any one of the preceding claims, wherein the protruding shape (11; 24) has a cross-section in a plan perpendicular to the stacking direction, which is a triangle, or a square, or a hexagon, or an octagon.

9. Combination according to any one of the preceding claims, wherein there are resting means (17, 18) around the protruding shape which are configured to leave an empty space at the bottom of the protruding shape (11; 24) before and after the PCB (1; 20; 27) has reached its predetermined position on the metal body (2).

10. Combination according to the preceding claim, wherein the resting means are a flat bank (18) surrounding the protruding shape (11; 24), slightly projecting from a main face of the metal body (2; 19), and a groove (17) between the bottom of the protruding shape (11; 24) and the bank (18).

11. Combination according to the preceding claim, wherein the depth of the groove (17) is between 0.1 mm and 0.5 mm, preferably 0.3 mm.

12. Combination according to any one of the two preceding claims, wherein the width of the groove (17) is between 1 mm and 2 mm, preferably 1.5 mm.

13. Combination according to any one of the four preceding claims, wherein resting means are a set of at least one stud, the end of which serves as resting face for the PCB (1; 20; 27) in its predetermined position.

14. **Headlamp, side lamp, rear lamp, or light control unit** of a vehicle, comprising a combination according to any one of the preceding claims.
